# EUROPÄISCHE PATENTSCHRIFT

(11) **EP 2 399 282 B1**
(45) Veröffentlichungstag und Bekanntmachung des Hinweises auf die Patenterteilung: **09.04.2014**
(21) Anmeldenummer: 10704527.0
(22) Anmeldetag: 03.02.2010
(51) Int. Cl.: H01L 21/312, C07F 5/06, C07F 5/00, C07F 3/00

(54) **INTEGRIERTE SCHALTKREISE ENTHALTEND ISOLATIONSMATERIAL UND DESSEN VERWENDUNG IN INTEGRIERTEN SCHALTKREISEN**
INTEGRATED CIRCUITS COMPRISING INSULATION MATERIAL AND USE OF SAID MATERIAL IN INTEGRATED CIRCUITS
CIRCUITS INTÉGRÉS COMPRENANT MATÉRIAU ISOLANT ET UTILISATION DE CE MATÉRIAU DANS CIRCUITS INTÉGRÉS

(30) Priorität: 20.02.2009 DE 102009001044
(43) Veröffentlichungstag der Anmeldung: 28.12.2011
(73) Patentinhaber: Leibniz-Institut für Festkörper- und Werkstoffforschung Dresden e.V., 01069 Dresden (DE)
(72) Erfinder: SEIFERT, Gotthart, 01326 Dresden (DE); HERMANN, Helmut, 01217 Dresden (DE); ZAGORODNIY, Konstyantyn, 01705 Freital (DE); ZSCHECH, Ehrenfried, 01468 Moritzburg (DE)
(74) Vertreter: Rauschenbach, Marion
(86) Internationale Anmeldenummer: PCT/EP2010/051297
(87) Internationale Veröffentlichungsnummer: WO 2010/094562

(56) Entgegenhaltungen:
- "A class of lightweight, rigid polymers that could be useful for storing hydrogen fuel" Nanotechwire.com 20. November 2005 (2005-11-20), XP002585540 Gefunden im Internet: URL:http://nanotechwire.com/news.asp?nid=2 604> [gefunden am 2010-05-31]
- KUC A ET AL: "Metal-organic frameworks: structural, energetic, electronic, and mechanical properties" JOURNAL OF PHYSICAL CHEMISTRY B AMERICAN CHEMICAL SOCIETY USA, Bd. 111, Nr. 28, Juli 2007 (2007-07), Seiten 8179-8186, XP002585541 ISSN: 1089-5647
- MARK E DAVIS: "ORDERED POROUS MATERIALS FOR EMERGING APPLICATIONS" NATURE, NATURE PUBLISHING GROUP, LONDON, GB LNKD- DOI:10.1038/NATURE00785, Bd. 417, 20. Juni 2002 (2002-06-20), Seiten 813-821, XP002496065 ISSN: 0028-0836
- COTE A P ET AL: "Porous, crystalline, covalent organic frameworks" SCIENCE AMERICAN ASSOC. ADV. SCI USA LNKD- DOI:10.1126/SCIENCE.1120411, Bd. 310, Nr. 5751, 18. November 2005 (2005-11-18), Seiten 1166-1170, XP002585542 ISSN: 0036-8075
- GARNER C M ET AL: "Challenges for dielectric materials in future integrated circuit technologies" MICROELECTRONICS AND RELIABILITY, ELSEVIER SCIENCE LTD, GB LNKD- DOI:10.1016/J.MICROREL.2004.11.053, Bd. 45, Nr. 5-6, 1. Mai 2005 (2005-05-01), Seiten 919-924, XP004779586 ISSN: 0026-2714

## Beschreibung

Die Erfindung bezieht sich auf die Gebiete der Mikroelektronik und der Materialwissenschaften und betrifft ein Isolationsmaterial für integrierte Schaltkreise in der Mikroelektronik, welches beispielsweise in integrierten Schaltkreisen als Isolationsmaterial in Halbleiterbauelementen zur Anwendung kommen kann.

Die Entwicklung und Optimierung von Isolationsmaterialien mit sehr guten dielektrischen Eigenschaften (Dielektrizitätskonstante k möglichst < 3) ist eine der dringendsten aktuellen Aufgaben der Mikroelektronik. Dies liegt vor allem darin, dass auf diesem Gebiet ein Rückstand von mehreren Jahren im Vergleich zur "roadmap" der internationalen Halbleiterindustrie besteht (M. Eizenberg, Interlayer Dielectrics for Semiconductor Technologies, Elsevier Acadamie Press, Amsterdam 2003, p.5; R.D. Miller, Science 286 (1999) 421-422).

Nach dieser "roadmap" werden seit Jahren Isolationsmaterialien gefordert, die eine statische dielektrische Konstante k < 2 und insbesondere k < 1,6 aufweisen, gleichzeitig eine Energielücke von ≥ 3 eV und einen mechanischen Kompressionsmodul B von ≥ 6 GPa besitzen.
Ein derartiges Isolationsmaterial ist aber noch nicht bekannt.

Bekannt ist der Einsatz von homogenem SiO₂ als Dielektrikum in der Mikroelektronik (Miller, R.D., Science 286 (1999) 421-422). Unter anderem kann das SiO₂ durch plasmagestützte chemische Dampfabscheidung (PE-CVD) aufgebracht werden. Derartige Dielektrika erreichen Werte für die Dielektrizitätskonstante von k = 3,9 bis 4,2. Mit zunehmender Integrationsdichte und steigender Leistung pro Chip kann das Dielektrikum SiO₂ aufgrund des hohen k-Wertes zukünftig nicht mehr eingesetzt werden.

Weiterhin sind als Dielektrika poröse SiO₂-Materialien bekannt (Zhang, J.-Y. u.a., Mater. Sci. in Semiconductor Processing 3 (2000) 345-349; Murray, C. u.a., Microelectronic Engng. 60 (2002)133-141), wobei sich diese Materialien gegenwärtig noch in der Testphase für den Einsatz befinden. Aufgebracht werden können diese Materialien unter anderem durch katalytische Sol-Gel-Polymerisation von Orthosilicat-Estern. Das Solvent wird aus der Gelschicht durch überkritische Extraktion entfernt (Aerogele) oder durch Solventaustausch und Trocknung (Xerogele) beseitigt. Derartige Dielektrika erreichen Werte für die Dielektrizitätskonstante von k = 1,7 bis 3,6.
Die Nachteile dieser Dielektrika sind der sehr hohe Herstellungsaufwand. Die Porositätsgrade liegen mit 50 bis 80 % sehr hoch und die Poren sind ungünstigerweise offen und zum großen Teil miteinander verbunden. Weiterhin ist die Porengrößenverteilung nicht ausreichend gut beherrschbar. Es können Poren und Kanäle miteinander verbundener Poren entstehen, die zur elektrischen Verbindung benachbarter Leitbahnen führen, die von dem Dielektrikum getrennt werden sollten. Dies kann zum Ausfall des Chips führen.

Auch bekannt ist der Einsatz von homogenen Polymeren als Dielektrika. Allerdings erreichen nur die hochfluorierten Alkan-Derivate k-Werte von < 2,2, wie beispielsweise PTFE mit k-Werten von 1,9 bis 2,1 (Wang, J. u.a., Scripta mater. 42 (2000) 687-694). PTFE-Schichten können aus Surfactant-stabilisierten wässrigen Mikroemulsionen hergestellt werden.

Weiterhin bekannt ist nach der DE 102 53 855.7 A1 ein Isolationsschichtmaterial für integrierte Schaltkreise in Damascene-Architektur, die aus durch Moleküle oder Molekülgruppen voneinander getrennt angeordnet Fullerenen bestehen. Dabei sind die Moleküle oder Molekülgruppen über mindestens zwei Stellen mit den Fullerenen über chemische und/oder physikalische Wechselwirkungen verbunden. Dieses Isolationsschichtmaterial weist k-Werte von < 4,0 bei einer einstellbaren Porengröße von < 2,0 nm auf.

Die bekannten Isolationsmaterialien für integrierte Schaltkreise werden entweder mittels CVD oder spin-on-Prozessen hergestellt.

Allen bekannten Lösungen ist gemeinsam, dass ihre mechanische Festigkeit mit kleiner werdenden k-Werten signifikant schlechter wird.

Weiterhin sind metallorganische Frameworks (MOFs) (O.M. Yaghi, u.a., Nature 423, 705 (2003))und kovanlente Frameworks (COFs) (A.P. Cöté, u.a. Science 310, 1166 (2005)) bekannt. Diese Materialien sind koordinationspolymere Verbindungen, die zu einem regelmäßigen Raumnetzwerk verknüpft sind. Der Prototyp der metallorganischen Frameworks ist MOF-5, in dem Zn₄O-Baueinheiten über Terephtalat-Brücken zu einem Zeolith-ähnlichen kubischen Raumnetz verknüpft sind (H. Li, u.a. Nature 402, 276, (1999)).
Der besondere Vorteil dieser MOFs und COFs sind ihre extrem große spezifische Oberfläche, aufgrund dessen sie bisher zur Adsorption und Speicherung von Gasen und als Sensoren angewandt wurden.
Die bekannten Eigenschaften und Anwendungen von MOFs (http.//www.mdpi.org/ijms/specialissues/frameworks) und COFs (A.P. Côté, u.a. Science 2005, 310, 1166-1170) beruhen auf ihrer enorm hohen spezifischen Oberfläche von teilweise mehreren 1000 m²/g. Einige MOFs werden bereits kommerziell hergestellt und auf entsprechenden Datenblättern charakterisiert, beispielsweise angegeben in Datenblättern der Fa. BASF/Sigma-Aldrich (www. Sigmaaldrich.com/Produkte, Produktnummern 688738, 688614).

Weiterhin sind bekannt "A class of lightweight, rigid polymers that could be useful for storing hydrogen fuel" gefunden am http://nanotechwire.com/news.asp?nid=2604; und "Metal-organic frameworks: structural, energetic, electronic, and mechanical properties" von Kuc et al. in JOURNAL OF PHYSICAL CHEMISTRY B AMERICAN CHEMICAL SOCIETY USA Vol. 111 No. 28, Juli 2007, Seite 8179-8186.

Angaben oder Hinweise zu besonders niedrigen dielektrischen Konstanten von MOFs und COFs sind aus dem Stand der Technik nicht bekannt.

Die Aufgabe der vorliegenden Erfindung besteht in der Angabe von integrierten Schaltkreisen, die ein Isolationsmaterial enthalten, welches Dielektrizitätskonstanten von k ≤ 2 bei gleichzeitig guten mechanischen Eigenschaften aufweist.

Die Aufgabe wird durch die in den Ansprüchen angegebene Erfindung gelöst. Vorteilhafte Ausgestaltungen sind Gegenstand der Unteransprüche.

Die erfindungsgemäßen integrierten Schaltkreise enthalten Isolationsmaterial ausschließlich bestehend aus IRMOFs, die ein isoreticulares kubisches Netzwerk mit analogem Bauprinzip aufweisen, mit Dielektrizitätskonstanten von k ≤ 2, und vorzugsweise Haftvermittler, wie Parylene, bei dem als Isolationsmaterial IRMOF-1 FCC, IRMOF-1 SC, IRMOF-10, IRMOF-M11, IRMOF-M13 und/oder IRMOF-14 verwendet wird.

Ebenfalls vorteilhafterweise sind IRMOFs in kristalliner bis ungeordneter, freier Form vorhanden.

Vorteilhaft ist es auch, wenn als zentrales Atom im Netzwerk ein Metallatom vorhanden ist, wobei noch vorteilhafterweise als Metallatom Cu oder Zn vorhanden ist.

Bei der erfindungsgemäßen Verwendung werden ausschließlich IRMOFs, die ein isoreticulares kubisches Netzwerk mit analogem Bauprinzip aufweisen, mit Dielektrizitätskonstanten von k ≤ 2 und vorzugsweise Haftvermittler, wie Parylene, in Form von IRMOF-1 FCC, IRMOF-1 SC, IRMOF-10, IRMOF-M11, IRMOF-M13 und/oder IRMOF-14 als Isolationsmaterial für integrierte Schaltkreise eingesetzt.

IRMOFs werden vorteilhafterweise in kristalliner bis ungeordneter, freier Form als Isolatormaterial mit Dielektrizitätskonstanten von k ≤ 2 für integrierte Schaltkreise verwendet.

Vorteilhaft ist es auch, wenn IRMOFs mit einem zentralen Metallatom im Netzwerk als Isolatormaterial mit Dielektrizitätskonstanten von k ≤ 2 für integrierte Schaltkreise verwendet werden, wobei noch vorteilhafterweise Cu oder Zn als Metallatom für Isolatormaterial mit Dielektrizitätskonstanten von k ≤ 2 für integrierte Schaltkreise verwendet werden.

Mit der erfindungsgemäßen Lösung werden erstmals ausschließlich IRMOFs als Isolationsmaterial oder in Isolationsmaterialien eingesetzt und verwendet.
Bisher waren die besonders niedrigen dielektrischen Konstanten und ihre Kombination mit ausreichend guten mechanischen Eigenschaften der IRMOFs nicht bekannt.
Es ist erfindungsgemäß festgestellt worden, dass die IRMOFs trotz des Vorhandenseins von Metallatomen sehr gute bis ausgezeichnete isolierende Eigenschaften bei besonders niedrigen statischen dielektrischen Konstanten und zum größten Teil gleichzeitig noch sehr guten bis ausgezeichneten mechanischen Eigenschaften aufweisen.
Je nach spezieller Anforderung kann bei der Auswahl der einzusetzenden IRMOFs der Aspekt der niedrigen dielektrischen Konstanten oder der Aspekt des hohen Kompressionsmoduls betont werden. Hinzu kommt noch, dass mit der Auswahl der IRMOFs auch die Breite der Energiebandlücke des Isolationsmaterials variiert werden kann.

Ein weiterer Vorteil der erfindungsgemäßen Lösung besteht darin, dass das Isolationsmaterial eine strukturelle Homogenität mit monodisperser Porengröße aufweist, die einen weiteren Vorteil gegenüber porösen Materialien mit endlicher Breite der Porengrößenverteilung ist, was sich besonders im Hinblick auf die Produktzuverlässigkeit auswirkt.

Ebenfalls kann mit der erfindungsgemäßen Lösung die Signalverzögerung verbessert werden, die bisher als begrenzender Faktor bei integrierten Schaltkreisen auftritt. Ursache der Signalverzögerung ist das RC-Produkt, also Widerstand mal Kapazität. Die Kapazität des Isolationsmaterials kann durch die Anwendung von porösen bis zellularen Materialien reduziert werden. Jedoch muss dann die mechanische Festigkeit für die technologischen Prozesse berücksichtigt werden, die mit steigendem porösen oder zellularen Anteil sinkt.

Dabei ist für die erfindungsgemäße Lösung die Anzahl, Art, Struktur, Größe und/oder Länge der IRMOFs in der gesamten bekannten Bandbreite anwendbar und einsetzbar.
Bei der Auswahl der konkreten Materialien sollte jedoch berücksichtigt werden, dass in jedem Einzelfall die Eigenschaften aus den Koordinaten der Atome in der Elementarzelle neu bestimmt werden müssen.
Weiterhin ist zu berücksichtigen, dass je geringer die Polarisierbarkeit der zwischenatomaren Bindungen der IRMOFs ist, desto besser die dielektrischen Eigenschaften sind. Ebenso sind die dielektrischen Eigenschaften umso besser, je geringer die Anzahl von Atomen pro Volumen ist, wodurch andererseits im Mittel die mechanische Stabilität verschlechtert wird.

Nachfolgend wird die Erfindung an einem Ausführungsbeispiel näher erläutert.

### Beispiel 1

### Dabei zeigt

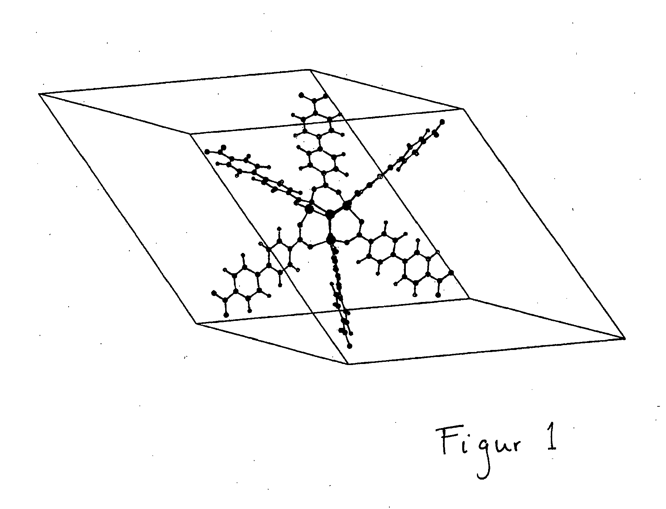

Fig.1: die Anordnung der Atome im metallorganischen Framework IRMOF-10.
Fig.1 zeigt den atomaren Aufbau des metallorganischen Frameworks IRMOF-10. Die Koordinaten der 166 Atome der Elementarzelle sind in Tabelle 1 angegeben.

**Tabelle 1:**

| Koordinaten der Atome von IRMOF-10. Atomsorte, x-,y-,z-Koordinaten sowie Transformationsmatrix. | | | |
|---|---|---|---|
| C | 17.69545500 | 31.52594000 | 17.64974900 |
| C | 17.65012100 | 17.65330200 | 3.82251600 |
| C | 17.68594600 | 3.80991400 | 17.65938200 |
| C | 17.65899300 | 17.66272200 | 31.53854200 |
| C | 3.82249800 | 17.69872400 | 17.69584300 |
| C | 31.53852400 | 17.68905700 | 17.68559300 |
| O | 32.18758700 | 16.66136200 | 18.18911000 |
| O | 32.19274800 | 18.72468700 | 17.19541900 |
| O | 17.04497800 | 32.17148600 | 18.59328100 |
| O | 18.34957300 | 32.17146800 | 16.70818000 |
| O | 18.59389900 | 18.30374400 | 3.17728800 |
| O | 16.70839200 | 16.99962600 | 3.17677600 |
| O | 17.66837800 | 0.00825400 | 17.66836000 |
| O | 17.19619700 | 3.15569100 | 16.62350400 |
| O | 18.18914500 | 3.16101000 | 18.68727100 |
| O | 16.62325600 | 18.15298400 | 32.19257100 |
| O | 18.68661700 | 17.15934700 | 32.18774600 |
| O | 3.17689900 | 16.75487500 | 17.04580800 |
| O | 3.17712900 | 18.64045300 | 18.34985500 |
| Zn | 16.47421100 | 16.47901800 | 1.18434100 |
| Zn | 16.46673400 | 1.20790000 | 16.46654000 |
| Zn | 1.19556400 | 16.49004700 | 16.47437000 |
| Zn | 1.18405800 | 1.19996400 | 1.19529800 |
| C | 5.98969500 | 16.75332000 | 16.93237600 |
| C | 5.27866600 | 17.69865400 | 17.69273300 |
| C | 7.38055700 | 16.75989500 | 16.92475800 |
| C | 5.99116200 | 18.64469400 | 18.45158700 |
| C | 8.10432900 | 17.69861800 | 17.69071800 |
| C | 7.38165300 | 18.63778400 | 18.45666000 |
| C | 10.30234900 | 16.60814500 | 17.16288100 |
| C | 9.57861300 | 17.69808800 | 17.69105400 |
| C | 11.69333500 | 16.61196200 | 17.15400900 |
| C | 10.30174800 | 18.78826100 | 18.22087000 |
| C | 11.69231000 | 18.78463800 | 18.23142100 |
| C | 12.40604200 | 17.69845900 | 17.69294500 |
| H | 5.44004900 | 16.01298800 | 16.33879200 |
| H | 5.44162200 | 19.38442600 | 19.04534800 |
| H | 12.24167300 | 15.76320000 | 16.72732100 |
| H | 12.24064800 | 19.63258800 | 18.65927600 |
| H | 9.77366400 | 19.65839200 | 18.62594200 |
| H | 7.90924200 | 19.37283200 | 19.07465200 |
| H | 7.90759800 | 16.02543000 | 16.30556400 |
| H | 9.77467100 | 15.73720100 | 16.75825100 |
| C | 18.21282800 | 5.97857800 | 18.75439800 |
| C | 17.67679100 | 5.26680700 | 17.66547900 |
| C | 18.20233000 | 7.36944000 | 18.76081300 |
| C | 17.13619400 | 5.98126400 | 16.58112100 |
| C | 17.67424600 | 8.09390100 | 17.67087000 |
| C | 17.14460600 | 7.37195000 | 16.58000800 |
| C | 18.44144200 | 10.29241600 | 18.60833900 |
| C | 17.67507600 | 9.56837900 | 17.67067600 |
| C | 18.43642300 | 11.68308400 | 18.61229800 |
| C | 16.90917000 | 10.29093100 | 16.73159800 |
| C | 16.91634600 | 11.68144000 | 16.72231900 |
| C | 17.67801000 | 12.39383000 | 17.66519700 |
| H | 18.63930400 | 5.42937300 | 19.60261200 |
| H | 16.70961200 | 5.43329700 | 15.73237600 |
| H | 19.03136800 | 12.23301300 | 19.35162300 |
| H | 16.32193100 | 12.23025600 | 15.98195200 |
| H | 16.29052400 | 9.76272400 | 15.99697500 |
| H | 16.73965800 | 7.90056400 | 15.71035400 |
| H | 18.60681900 | 7.89632200 | 19.63191600 |
| H | 19.06070700 | 9.76532200 | 19.34335100 |
| C | 18.59529500 | 18.41583300 | 5.98992500 |
| C | 17.64994400 | 17.65572300 | 5.27866600 |
| C | 18.58852600 | 18.42322100 | 7.38078700 |
| C | 16.70392100 | 16.89662100 | 5.99093200 |
| C | 17.64964300 | 17.65736700 | 8.10432900 |
| C | 16.71061900 | 16.89131900 | 7.38144100 |
| C | 18.74001100 | 18.18564500 | 10.30219000 |
| C | 17.65001500 | 17.65724300 | 9.57863000 |
| C | 18.73642300 | 18.19457100 | 11.69317600 |
| C | 16.55991200 | 17.12765700 | 10.30188900 |
| C | 16.56373000 | 17.11715900 | 11.69248600 |
| C | 17.65010300 | 17.65551100 | 12.40600700 |
| H | 19.33573400 | 19.00941700 | 5.44045500 |
| H | 15.96427800 | 16.30286000 | 5.44123300 |
| H | 19.58522100 | 18.62140000 | 12.24130200 |
| H | 15.71581600 | 16.68948100 | 12.24100200 |
| H | 15.68962300 | 16.72269100 | 9.77396400 |
| H | 15.97564200 | 16.27323900 | 7.90897700 |
| H | 19.32306100 | 19.04230800 | 7.90786400 |
| H | 19.61081300 | 18.59040000 | 9.77438900 |
| C | 17.68523900 | 13.85089900 | 17.65876300 |
| C | 17.65005000 | 17.65264800 | 13.86335900 |
| C | 17.69557800 | 21.48497300 | 17.64976700 |
| C | 17.65846300 | 17.66300500 | 21.49746900 |
| C | 21.49748600 | 17.68987000 | 17.68516800 |
| C | 13.86335900 | 17.69888300 | 17.69557800 |
| O | 14.51544500 | 16.66553300 | 17.20307200 |
| O | 14.51487900 | 18.73052000 | 18.19262700 |
| O | 17.03997600 | 14.49833600 | 16.71109600 |
| O | 18.34207900 | 14.49425300 | 18.59798200 |
| O | 18.68363100 | 18.14497700 | 14.51532100 |
| O | 16.61860800 | 17.15551100 | 14.51502000 |
| O | 17.67005700 | 17.67845200 | 17.67007500 |
| O | 17.20321400 | 20.83297600 | 18.68327700 |
| O | 18.19264400 | 20.83334700 | 16.61821900 |
| O | 16.71079600 | 18.30833900 | 20.85006700 |
| O | 18.59764600 | 17.00614800 | 20.85409700 |
| O | 20.85404400 | 16.75072200 | 18.34206100 |
| O | 20.85012000 | 18.63755400 | 17.03985200 |
| Zn | 16.46371200 | 16.48216400 | 16.47726800 |
| Zn | 16.47709100 | 18.88477900 | 18.86622100 |
| Zn | 18.86307600 | 16.48522200 | 18.86311100 |
| Zn | 18.86627500 | 18.87111700 | 16.46351800 |
| C | 29.36717400 | 18.76728200 | 17.13619400 |
| C | 30.08164900 | 17.68287100 | 17.67661400 |
| C | 27.97648900 | 18.76836000 | 17.14478300 |
| C | 29.36996700 | 16.59395300 | 18.21277500 |
| C | 27.25455500 | 17.67744500 | 17.67438700 |
| C | 27.97910400 | 16.58757200 | 18.20241800 |
| C | 25.05759500 | 18.61671600 | 16.90917000 |
| C | 25.78007700 | 17.67767500 | 17.67514700 |
| C | 23.66706900 | 18.62610100 | 16.91625700 |
| C | 25.05591600 | 16.74001100 | 18.44142500 |
| C | 23.66524900 | 16.73612300 | 18.43633500 |
| C | 22.95457400 | 17.68327700 | 17.67794000 |
| H | 29.91507100 | 19.61604500 | 16.70959400 |
| H | 29.91922400 | 15.74573800 | 18.63916300 |
| H | 23.11832400 | 19.36648700 | 16.32178900 |
| H | 23.11523100 | 15.99679800 | 19.03119100 |
| H | 25.58292200 | 16.00491100 | 19.06068900 |
| H | 27.45225700 | 15.71650500 | 18.60697800 |
| H | 27.44792700 | 19.63806700 | 16.73997600 |
| H | 25.58583900 | 19.35125100 | 16.29047100 |
| C | 18.45162300 | 29.35740000 | 16.70376200 |
| C | 17.69262700 | 30.06980700 | 17.64978500 |
| C | 18.45681900 | 27.96690900 | 16.71061900 |
| C | 16.93244700 | 29.35869000 | 18.59517200 |
| C | 17.69087700 | 27.24411000 | 17.64976700 |
| C | 16.92500600 | 27.96781100 | 18.58854400 |
| C | 18.22079900 | 25.04660200 | 16.56008900 |
| C | 17.69112400 | 25.76980800 | 17.65019100 |
| C | 18.23126200 | 23.65598700 | 16.56374800 |
| C | 17.16279300 | 25.04612500 | 18.74013500 |
| C | 17.15383200 | 23.65512100 | 18.73638800 |
| C | 17.69280400 | 22.94234300 | 17.64999700 |
| H | 19.04534800 | 29.90701100 | 15.96403000 |
| H | 16.33888000 | 29.90823100 | 19.33562800 |
| H | 18.65901000 | 23.10756000 | 15.71578000 |
| H | 16.72703800 | 23.10687100 | 19.58516800 |
| H | 16.75810900 | 25.57382000 | 19.61104300 |
| H | 16.30590000 | 27.44080500 | 19.32306100 |
| H | 19.07482900 | 27.43937300 | 15.97564200 |
| H | 18.62594200 | 25.57456200 | 15.68990500 |
| C | 16.58103300 | 18.21217400 | 29.36712100 |
| C | 17.66537300 | 17.67164800 | 30.08163100 |
| C | 16.58000800 | 18.20365500 | 27.97645300 |
| C | 18.75432700 | 17.13552200 | 29.37002000 |
| C | 17.67095800 | 17.67406900 | 27.25457300 |
| C | 18.76077800 | 17.14596700 | 27.97914000 |
| C | 16.73172200 | 18.43926900 | 25.05756000 |
| C | 17.67079900 | 17.67332700 | 25.78007700 |
| C | 16.72224900 | 18.43202200 | 23.66703400 |
| C | 18.60842700 | 16.90701400 | 25.05595200 |
| C | 18.61224500 | 16.91194500 | 23.66526600 |
| C | 17.66502000 | 17.67025100 | 22.95457400 |
| H | 15.73227000 | 18.63877400 | 29.91501800 |
| H | 19.60252400 | 16.70908200 | 29.91927700 |
| H | 15.98184600 | 19.02643700 | 23.11828900 |
| H | 19.35149900 | 16.31701700 | 23.11528400 |
| H | 19.34363400 | 16.28790800 | 25.58297500 |
| H | 19.63188100 | 16.74142500 | 27.45234600 |
| H | 15.71035400 | 18.60849800 | 27.44783900 |
| H | 15.99724000 | 19.05807400 | 25.58578600 |

### #transformation matrix

| | | |
|---|---|---|
| 0.000000 | 17.674087 | 17.674087 |
| 17.674087 | 0.000000 | 17.674087 |
| 17.674087 | 17.674087 | 0.000000 |

Die Eigenschaften dieses IRMOF-10 sind folgende;

Dielektrizitätskonstante k = 1,23
Mechanischer Kompressionsmodul B = 6,00 GPa
Energiebandlücke E_{g} = 3,07 eV.

### Beispiele 2 - 6

Die nachfolgenden metallorganischen Frameworks zeigen die dazu aufgeführten Eigenschaften:

| | | | |
|---|---|---|---|
| IRMOF-1, FCC | k = 1,37 | B = 8,7 GPa | E_{g} = 3,73 |
| IRMOF-1, SC | k = 1,39 | B = 6,33 GPa | E_{g} = 3,66 |
| IRMOF-M11 | k = 1,45 | B = 12,00 GPa | E_{g} = 4,91 |
| IRMOF-M13 | k = 1,50 | B = 9,00 GPa | E_{g} = 5,49 |
| IRMOF-14 | k = 1,28 | B = 5,90 GPa | E_{g} = 2,63 |

### Beispiel 7 - kein Teil der Erfindung -

Das kovalente organische Framework COF-108 zeigt die nachfolgenden Eigenschaften: Massendichte: 0,17 g/cm³ und spezifische Oberfläche (BET): 4210 m²/g (H. M. EI-Kalderi u.a. Science 316 (2007) 268-272) sowie k = 1,4.

## Patentansprüche

1. Integrierte Schaltkreise enthaltend Isolationsmaterial aus ausschließlich IRMOFs, die ein isoreticulares kubisches Netzwerk mit analogem Bauprinzip aufweisen, mit Dielektrizitätskonstanten von k ≤ 2, und vorzugsweise Haftvermittler, wie Parylene, **gekennzeichnet dadurch, dass** als Isolationsmaterial IRMOF-1 FCC, IRMOF-1 SC, IRMOF-10, IRMOF-M11, IRMOF-M13 und/oder IRMOF-14 verwendet wird.

2. Isolationsmaterial nach Anspruch 1, bei dem IRMOFs in kristalliner bis ungeordneter, freier Form vorhanden sind.

3. Isolationsmaterial nach Anspruch 1, bei dem als zentrales Atom im Netzwerk ein Metallatom vorhanden ist.

4. Isolationsmaterial nach Anspruch 3, bei dem als Metallatom Cu oder Zn vorhanden ist.

5. Verwendung von ausschließlich IRMOFs, die ein isoreticulares kubisches Netzwerk mit analogem Bauprinzip aufweisen, mit Dielektrizitätskonstanten von k ≤ 2 und vorzugsweise Haftvermittler, wie Parylene, in Form von IRMOF-1 FCC, IRMOF-1 SC, IRMOF-10, IRMOF-M11, IRMOF-M13 und/oder IRMOF-14 als Isolationsmaterial für integrierte Schaltkreise.

6. Verwendung nach Anspruch 5 von IRMOFs in kristalliner bis ungeordneter, freier Form als Isolatormaterial mit Dielektrizitätskonstanten von k ≤ 2 für integrierte Schaltkreise.

7. Verwendung nach Anspruch 5, von IRMOFs mit einem zentralen Metallatom im Netzwerk als Isolatormaterial mit Dielektrizitätskonstanten von k ≤ 2 für integrierte Schaltkreise.

8. Verwendung nach Anspruch 5 von Cu oder Zn als Metallatom für Isolatormaterial mit Dielektrizitätskonstanten von k ≤ 2 für integrierte Schaltkreise.

## Claims

1. Integrated circuits comprising insulation material composed of exclusively IRMOFs which have an isoreticular cubic network having an analogous construction principle, with dielectric constants of k ≤ 2, and preferably bonding agents such as parylenes, **characterized in that** IRMOF-1 FCC, IRMOF-1 SC, IRMOF-10, IRMOF-M11, IRMOF-M13 and/or IRMOF-14 are/is used as insulation material.

2. Insulation material according to Claim 1, wherein IRMOFs are present in crystalline to disordered, free form.

3. Insulation material according to Claim 1, wherein a metal atom is present as central atom in the network.

4. Insulation material according to Claim 3, wherein Cu or Zn is present as metal atom.

5. Use of exclusively IRMOFs which have an isoreticular cubic network having an analogous construction principle, with dielectric constants of k ≤ 2 and preferably bonding agents such as parylenes, in the form of IRMOF-1 FCC, IRMOF-1 SC, IRMOF-10, IRMOF-M11, IRMOF-M13 and/or IRMOF-14 as insulation material for integrated circuits.

6. Use according to Claim 5 of IRMOFs in crystalline to disordered, free form as insulation material having dielectric constants of k ≤ 2 for integrated circuits.

7. Use according to Claim 5 of IRMOFs having a central metal atom in the network as insulation material having dielectric constants of k ≤ 2 for integrated circuits.

8. Use according to Claim 5 of Cu or Zn as metal atom for insulation material having dielectric constants of k ≤ 2 for integrated circuits.

## Revendications

1. Circuits intégrés comprenant un matériau isolant composé exclusivement de IRMOF, qui présentent un réseau cubique isoréticulaire avec un principe de construction analogique, avec des constantes diélectriques de k ≤ 2, et de préférence des agents adhésifs, comme le parylène, **caractérisés en ce que** l'on utilise comme matériau isolant les IRMOF-1 FCC, IRMOF-1 SC, IRMOF-10, IRMOF-M11, IRMOF-M13 et/ou IRMOF-14.

2. Matériau isolant selon la revendication 1, dans lequel il se trouve des IRMOF sous une forme cristalline à une forme libre désordonnée.

3. Matériau isolant selon la revendication 1, dans lequel il se trouve un atome de métal comme atome central dans le réseau.

4. Matériau isolant selon la revendication 3, dans lequel il se trouve du Cu ou du Zn comme atome de métal.

5. Utilisation exclusivement de IRMOF, qui présentent un réseau cubique isoréticulaire avec un principe de construction analogique, avec des constantes diélectriques de k ≤ 2, et de préférence des agents adhésifs, comme le parylène, sous la forme de IRMOF-1 FCC, IRMOF-1 SC, IRMOF-10, IRMOF-M11, IRMOF-M13, et/ou IRMOF-14, comme matériau isolant pour des circuits intégrés.

6. Utilisation selon la revendication 5 de IRMOF sous une forme cristalline à une forme libre désordonnée comme matériau isolant avec des constantes diélectriques de k ≤ 2 pour des circuits intégrés.

7. Utilisation selon la revendication 5 de IRMOF avec un atome de métal central dans le réseau comme matériau isolant avec des constantes diélectriques de k ≤ 2 pour des circuits intégrés.

8. Utilisation selon la revendication 5 de Cu ou de Zn comme atome de métal pour un matériau isolant avec des constantes diélectriques de k ≤ 2 pour des circuits intégrés.
